# EUROPÄISCHE PATENTSCHRIFT

(11) **EP 1 953 915 B1**
(45) Veröffentlichungstag und Bekanntmachung des Hinweises auf die Patenterteilung: **13.04.2016**
(21) Anmeldenummer: 08100415.2
(22) Anmeldetag: 14.01.2008
(51) Int. Cl.: H03K 17/96, G06F 3/033, G06F 3/044, D06F 39/00

(54) **Kapazitiver Inkrementalgeber und Haushaltsgerät mit einem solchen**
Capacitative incremental encoder and household device with such an encoder
Encodeur incrémentiel capacitif et appareil ménager doté de celui-ci

(30) Priorität: 31.01.2007 DE 102007004889
(43) Veröffentlichungstag der Anmeldung: 06.08.2008
(73) Patentinhaber: BSH Hausgeräte GmbH, 81739 München (DE)
(72) Erfinder: Klopfer, Wilfried, 93057 Regensburg (DE); Pham, Ngoc Hung, 93053 Regensburg (DE); Reinker, Bernward Maria, 93128 Regenstauf (DE); Romanowski, Hans-Jürgen, 93170 Bernhardswald (DE)

(56) Entgegenhaltungen:
- EP-A1- 1 122 886
- EP-A1- 1 198 063
- EP-A1- 1 204 209
- WO-A1-00/42628
- DE-U1-202005 002 157
- US-A- 4 321 479
- US-A- 5 917 165

## Beschreibung

Die Erfindung bezieht sich auf einen kapazitiven Inkrementalgeber mit zumindest drei Gruppen von einzelnen Sensorflächen, wobei alle Sensorflächen derselben Gruppe miteinander elektrisch leitend verbunden sind, wobei die Sensorflächen von einer elektrisch isolierenden Abdeckplatte abgedeckt sind und Teile von Kondensatoren mit durch Berührung der Abdeckplatte veränderlicher Kapazität sind, wobei jeweils zwischen zwei Sensorflächen derselben Gruppe je eine Sensorfläche von jeder der anderen Gruppen angeordnet ist.

Es sind bereits zahlreiche Vorrichtungen mit kapazitiven Sensoren oder Schaltern bekannt. Bei einer speziellen Bauart dieser kapazitiven Sensoren, ist eine elektrisch leitende Sensorfläche von einer elektrisch isolierenden Abdeckplatte abgedeckt. Ein Benutzer berührt also die Sensorfläche nicht direkt, sondern nähert sich ihr bei Berührung der Abdeckplatte lediglich an. Die Sensorfläche bildet eine Platte eines offenen Kondensators, dessen Kapazität von dem Abstand zu einer zweiten Platte (z.B. Erde) abhängt, der beispielsweise durch Annäherung eines Fingers des Benutzers verändert wird.

Die vorliegende Erfindung bezieht sich auf eine spezielle Anordnung von kapazitiv wirkenden Schaltern, bei der mehrere Schalter nebeneinander angeordnet sind und zusammen einen Inkrementalgeber bilden. Bei Betätigung des Inkrementalgebers kann sowohl eine zurückgelegte Betätigungsstrecke als auch eine Betätigungsrichtung erfasst werden. Im Gegensatz zu kontinuierlich arbeitenden Messsystemen, wie beispielsweise Potentiometern, sind bei Inkrementalgebern diskrete Schritte vorgegeben, die bei Betätigung des Inkrementalgebers gezählt werden. Die Schrittweite kann dabei an die jeweilige Anwendung angepasst sein. Bei Berührung des kapazitiven Inkrementalgebers innerhalb seines Berührbereichs ist für die mit den Sensorflächen gebildeten Kondensatoren die Kapazitätsänderung jeweils von der Berührposition längs des Berührbereichs abhängig. Dadurch kann bei Gleiten entlang des Berührbereichs durch den Inkrementalgeber eine entsprechende Anzahl an Schritten gezählt und je nach Betätigungsrichtung eine entsprechende Erhöhung bzw. Erniedrigung eines vorgegebenen Wertes eingestellt werden.

Ein solcher kapazitiver Inkrementalgeber ist bereits aus EP 0 299 204 A2 bekannt. Dort sind gegenseitig elektrisch isolierte Elektroden nebeneinander angeordnet, die von einer elektrisch isolierenden Schicht bedeckt sind, wobei die den Elektroden abgewandte Seite der Schicht als Auflagefläche für einen Finger eines Benutzers dient. Die Elektroden bilden wenigstens drei Gruppen, wobei alle Elektroden einer Gruppe miteinander elektrisch leitend verbunden sind. Zwischen zwei Elektroden der ersten Gruppe ist je eine Elektrode von jeder der anderen beiden Gruppen angeordnet, wobei alle Elektroden der ersten Gruppe an eine Wechselspannungsquelle und alle Elektroden der anderen Gruppen an eine Signalauswerteschaltung angeschlossen sind. Bei Berührung der Auflagefläche ändert sich die kapazitive Kopplung zwischen der Elektrode der ersten Gruppe und den benachbart angeordneten Elektroden der beiden andern Gruppen, so dass die Position der Berührung bezüglich den Elektroden der ersten Gruppe bestimmt werden kann.

In Dokument US 4 321 479 ist ein kapazitiver Inkrementalgeber mit Gruppen von einzelnen Sensorflächen gezeigt, wobei alle Sensorflächen derselben Gruppe miteinander elektrisch leitend verbunden sind. Die Sensorflächen sind von einer elektrisch isolierenden Abdeckplatte abgedeckt, so dass offene Kondensatoren mit durch Berührung der Abdeckplatte veränderlicher Kapazität gebildet sind. Zwischen zwei Sensorflächen derselben Gruppe ist je eine Sensorfläche von jeder der anderen Gruppen angeordnet.

Der vorliegenden Erfindung liegt die Aufgabe zugrunde, einen verbesserten, kostengünstigen kapazitiven Inkrementalgeber zur Verfügung zu stellen.

Gelöst wird die vorstehend aufgezeigte Aufgabe durch einen kapazitiven Inkrementalgeber mit den Merkmalen des Anspruchs 1. Vorteilhafte sowie bevorzugte Ausgestaltungen der Erfindung sind Gegenstand der abhängigen Ansprüche.

Bei einem kapazitiven Inkrementalgeber der eingangs genannten Art, ist erfindungsgemäß jede Gruppe von Sensorflächen derart mit einer Spannungsquelle elektrisch leitend verbunden, so dass an jede Gruppe ein Spannungssignal anlegbar ist. Des weiteren ist jede Gruppe derart mit einer Auswerteschaltung verbunden, so dass für jede Gruppe je ein Ausgangssignal auswertbar ist. Auf diese Weise kann eine Betätigungsrichtung und/oder eine Anzahl an Schritten des Inkrementalgebers aus Änderungen der Ausgangssignale der verschiedenen Gruppen bestimmt werden. Die Betätigungsrichtung folgt aus der zeitlichen Abfolge in der sich die Ausgangssignale von den verschiedenen Gruppen ändern. Auf diese Weise kann ein Inkrementalgeber ohne mechanisch zu verschiebende Elemente gebildet werden, indem der Benutzer beispielsweise mit einem Finger über einen dem Inkrementalgeber zugeordneten Bereich der Abdeckplatte bzw. der Blende streicht.

Die Sensorflächen sind längs einer dem Inkrementalgeber zugeordneten Berührfläche der Abdeckplatte angeordnet. Dadurch dass Sensorflächen verschiedener Gruppen abwechselnd aufeinander folgen und die Sensorflächen einer Gruppe zu jeweils demselben Ausgangssignal beitragen, wiederholt sich bei einem kontinuierlichen Überstreichen der Berührfläche die Änderung des Ausgangssignal periodisch. Der Inkrementalgeber kann verschieden ausgebildet sein, beispielsweise mit einer streifenförmigen Berührfläche, die linear, gebogen oder ringförmig ausgeführt sein kann. Ein Inkrementalgeber mit ringförmiger Berührfläche kann auch als "Drehgeber" oder "Drehimpulsgeber" bezeichnet werden.

Zur Auslösung eines Schrittes des Inkrementalgebers ist eine erste Signalschwelle für das Ausgangssignal vorgesehen. Überschreitet das Ausgangssignal einer Gruppe von Sensorflächen diese Signalschwelle, so wird das als ein Schritt des Inkrementalgebers mit einer vorgegebenen Schrittweite gezählt.

Erfindungsgemäß ist zur Auslösung eines Folgeschrittes des Inkrementalgebers eine zweite Signalschwelle für das Ausgangssignal vorgesehen. Auf diese Weise wird ein Schritt des Inkrementalgebers mit einer vorgegebenen Schrittweite gezählt sobald das Ausgangssignal einer Gruppe von Sensorflächen die erste Signalschwelle überschreitet und ein Folgeschritt wird gezählt, sobald dasselbe Ausgangssignal die zweite Signalschwelle überschreitet. Somit kann bei gleicher Geometrie des Inkrementalgebers bzw. gleicher Anzahl an Sensorflächen die Anzahl an Schritten des Inkrementalgebers verdoppelt werden. Analog können auch noch weitere Signalschwellen vorgesehen sein.

Damit eine Fehlbedienung, beispielsweise durch Verschmutzung, ausgeschlossen werden kann, ist vorzugsweise eine Betätigung des Inkrementalgebers aus den kumulierten Ausgangssignalen der verschiedenen Gruppen bestimmbar. D.h. eine Betätigung wird als gültig erkannt, wenn das kumulierte Signal aus allen Ausgangssignalen einen vorgegebenen Wert überschreitet. Aus diese Weise wird beispielsweise ein Ausgangssignal einer Gruppe von Sensorflächen, das die erste Signalschwelle überschreitet, nicht als Betätigung des Inkrementalgebers gewertet, wenn das kumulierte Signal aus allen Gruppen von Sensorflächen unterhalb des vorgegebenen Wertes liegt.

Gemäß einer bevorzugten Ausführungsform ist das Spannungssignal, das an die Sensorflächen bzw. die Gruppen von Sensorflächen anlegbar ist, ein Taktsignal. Vorzugsweise liegt an den Sensorflächen der verschiedenen Gruppen das Taktsignal in einem zeitlichen Multiplexverfahren an. Durch die hohe Frequenz des Taktsignals ist eine ausreichende Abfragehäufigkeit der Kapazitäten der mit den Sensorflächen gebildeten Kondensatoren zur Detektion einer Betätigung des Inkrementalgebers gewährleistet. Die Verwendung von nur einem Taktsignal hat den Vorteil, dass nur ein Taktsignalgeber nötig ist.

Vorzugsweise sind die Sensorflächen einer Gruppe jeweils mit einem Steuereingang eines Halbleiterschalters verbunden, der außerdem einen Signaleingang mit dem Taktsignal und einen Signalausgang hat. An dem Signalausgang des Halbleiterschalters liegt das dem Taktsignal folgende Ausgangssignal an, mit Signalanteilen, die proportional zur Kapazität der mit den Sensorflächen der Gruppe gebildeten Kondensatoren sind.

Dies bringt den Vorteil mit sich, dass das Ausgangssignal bei jedem Takt des Taktsignals zur Verfügung steht und somit Änderungen der Kapazität der mit den Sensorflächen einer Gruppe gebildeten Kondensatoren jederzeit ausgewertet werden können. Auf diese Weise kann, insbesondere durch Auswertung einer zeitlichen Änderung, festgestellt werden, ob es sich bei der Kapazitätsänderung um eine Betätigung des Inkrementalgebers durch einen Benutzer handelt, oder ob eine Fehlbedienung aufgrund von Feuchtigkeit oder Verunreinigungen auf der Abdeckplatte vorliegt.

Gemäß einer bevorzugten Ausführungsform ist der Steuereingang zur Versorgung der Sensorflächen mit dem Taktsignal ausgebildet, und das Ausgangssignal liegt während eines Aufladezeitraums der Kondensatoren durch das Taktsignal am Signalausgang des Halbleiterschalters an. Insbesondere weist der Halbleiterschalter einen Transistor auf, und die Sensorflächen einer Gruppe sind mit der Basis des Transistors verbunden. Da der Halbleiterschalter bzw. Transistor durchschaltet solange Ladungsträger auf die Sensorflächen einer Gruppe fließen, ist die Form des Ausgangssignals von der Kapazität der zugehörigen Kondensatoren abhängig und dadurch auf einfache Weise eine Messung dieser Kapazität ermöglicht.

Vorzugsweise ist der Signaleingang zur Versorgung mit dem Taktsignal mit einem Ausgang eines Mikroprozessors verbunden. Dieser Ausgang kann ein Analogausgang oder ein Digitalausgang, wie beispielsweise ein Timer-Ausgang, ein PWM-Ausgang oder ein I/O-Ausgang sein. Das Taktsignal, das insbesondere von dem Ausgang des Mikroprozessors ausgegeben wird, ist vorteilhafterweise ein periodisches Taktsignal, insbesondere ein Rechtecksignal und weist eine Frequenz bevorzugt im Bereich von 10 bis 100 Kilohertz auf. Dadurch ist eine ausreichende Abfragehäufigkeit der Kapazität der mit den Sensorflächen gebildeten Kondensatoren zur Detektion einer Betätigung des Inkrementalgebers gewährleistet. Darüber hinaus kann auf einen teuren, separaten Frequenzgenerator zur Erzeugung des Taktsignals verzichtet werden, wodurch sich die Anzahl der notwendigen Bauteile reduziert. Insbesondere ist die Frequenz des Taktsignals automatisch variierbar. Somit kann automatisch diejenige Frequenz ausgewählt werden, bei der das Ausgangssignal jeder der Gruppen von Sensorflächen einen maximalen Signalhub aufweist.

Vorzugsweise liegt das Taktsignal zyklisch jeweils für eine vorgegebene Zeitdauer an dem Signaleingang an. Auf diese Weise kann in festgelegten zeitlichen Abständen überprüft werden, ob eine Betätigung des Inkrementalgebers vorliegt. Die dazwischen liegenden Zeiträume können, insbesondere von dem Mikroprozessor, für anderweitige Funktionen genutzt werden.

Der Signalausgang des Halbleiterschalters ist zur Bearbeitung des Ausgangssignals beispielsweise mit einer Integratorschaltung oder einem Spitzenspannungsmesser oder gemäß einer bevorzugten Ausführungsform mit einer Sample and Hold-Schaltung verbunden. Bei Verwendung der Integratorschaltung können mehrere Impulse des Ausgangssignals zu einer Gleichspannung aufintegriert werden. Mit dem Spitzenspannungsmesser kann die Höhe der Ausgangssignalimpulse direkt bestimmt werden. Durch die Sample and Hold-Schaltung wird ein Gleichspannungssignal proportional zur Amplitude der Impulsspitzen des Ausgangssignals zur weiteren Verarbeitung zur Verfügung gestellt.

Vorteilhafterweise ist der Signalausgang des Halbleiterschalters zur Auswertung des Ausgangssignals mit einem Analogeingang eines Mikroprozessors, insbesondere über die dazwischen geschaltete Sample and Hold-Schaltung, verbunden. Auf diese Weise ist eine Auswertung des Ausgangssignal durch ein Software-Programm möglich, und es ist dafür keine Schwellwertschaltung notwendig, wodurch sich die Anzahl der Bauteile weiter reduziert.

Der Mikroprozessor ist zur Auswertung einer zeitlichen Änderung von Signalanteilen des Ausgangssignals, beispielsweise mit Hilfe eines Software-Programms, ausgebildet. Abhängig davon, wie schnell die Signalanteile des Ausgangssignals, wie beispielsweise die Höhe der Impulsspitze oder die Impulsbreite, von aufeinander folgenden Taktperioden sich ändern, wird von dem Mikroprozessor eine Betätigung des Inkrementalgebers erkannt. D.h. ändern sich die Signalanteile innerhalb eines vorgegebenen Zeitraums von beispielsweise einer Sekunde, so wird dies als Betätigung erkannt, ändern sich die Signalanteile langsamer, so liegt keine Betätigung vor. Auf diese Weise kann eine Betätigung des Inkrementalgebers auch unabhängig von der absoluten Größe des Ausgangssignals bestimmt werden, wodurch dessen langfristige Änderungen, z.B. durch Alterungsprozesse, eliminiert sind.

Erfindungsgemäß weisen die Sensorflächen eine aktive Abschirmung auf. Die aktive Abschirmung ist durch eine Abschirmfläche gebildet, an der zeitgleich mit der zugehörigen Sensorfläche das Taktsignal anliegt. Es kann auch eine Abschirmfläche für alle Sensorflächen einer Gruppe oder alle Sensorflächen des Inkrementalgebers vorgesehen sein. Werden die Sensorfläche und die benachbart zur Sensorfläche liegende Abschirmfläche zeitgleich mit einem möglichst identischen bzw. dem gleichen Taktsignal versorgt, so bringt dies den Vorteil mit sich, dass es zwischen der Sensorfläche und der Abschirmfläche zu keinem Potenzialunterschied, damit zu keiner Ladungsverschiebung und somit zu keiner kapazitiven Beeinflussung der Sensorfläche kommt. Dies ist insbesondere bei Kapazitäten des mit der Sensorfläche gebildeten Kondensators in der Größenordnung von Piko-Farad wichtig, da in diesem Bereich selbst kleine Störkapazitäten von beispielsweise Leitungen, benachbarten Sensorflächen oder Metallgehäusen eine Messung der Kapazität des Kondensators beeinflussen. Durch eine Minimierung des Einflusses dieser Störkapazitäten auf die Sensorfläche bzw. die Sensorflächen mit Hilfe der aktiven Abschirmung ist es möglich, den Inkrementalgeber in der Nähe von metallischen Gehäuseteilen anzuordnen, selbst wenn diese geerdet sind. Darüber hinaus ist es nun nicht mehr nötig die Sensorflächen in unmittelbarer Nähe zur Auswerteelektronik des Inkrementalgebers zu platzieren, um Störkapazitäten zu minimieren, sondern die Sensorflächen können zusammen mit der Abschirmfläche entfernt von der Auswerteelektronik angeordnet werden. Hierdurch wird es möglich, die Sensorflächen und die Verbindungsleitungen in Form einer preisgünstigen kupferkaschierten Polyesterfolie auszuführen, die einen Anschluss zu der Auswerteelektronik aufweist.

Vorzugsweise liegt das Taktsignal über einen niederohmigen Widerstand an der Abschirmfläche an. Auf diese Weise kann die Signalform des Taktsignals an der Abschirmfläche an die Signalform des Taktsignals an den Sensorflächen angeglichen werden.

Gemäß einer bevorzugten Ausführungsform ist die Abschirmfläche zum Anlegen von Massepotenzial über einen Schalter mit Masse verbindbar. Wobei hier unter Masse ein festes Potenzial, wie beispielsweise Erdpotenzial oder ein Bezugspotenzial des Inkrementalgebers, verstanden wird. Zur Funktionsprüfung des Inkrementalgebers, d.h. zur Ermittlung eines Referenzwertes des Ausgangssignals kann die Abschirmfläche durch den Schalter zeitweise mit Masse verbunden werden, wodurch die aktive Abschirmung zeitweise außer Kraft gesetzt und eine Betätigung des Inkrementalgebers simuliert wird. Auf diese Weise kann überprüft werden, ob ein ausreichender Signalhub des Ausgangssignals bzw. der Ausgangssignale bei Betätigung des Inkrementalgebers vorliegt, oder ob eventuell aufgrund von Verunreinigungen oder Benetzung der Abdeckplatte oder aufgrund von Alterungsprozessen des Inkrementalgebers eine Fehlfunktion vorliegt. Auf diese Weise können Fehlbedienungen des Inkrementalgebers vermieden werden, wodurch die Funktionssicherheit des Inkrementalgebers verbessert wird. Insbesondere kann ein mit dem erfindungsgemäßen Inkrementalgeber ausgestattetes Gerät automatisch abgeschaltet werden, wenn eine sichere Funktion des Inkrementalgebers nicht mehr gewährleistet ist. Eventuell kann der Signalhub des Ausgangssignals durch Änderung der Höhe des Taktsignals dynamisch angepasst werden, d.h. der Inkrementalgeber kann automatisch kalibriert werden.

Vorteilhafterweise weist der Schalter einen Steuersignaleingang auf, der mit einem Steuersignalausgang eines Mikroprozessors verbunden ist. Insbesondere ist der Schalter ein Transistor, wie z.B. ein PNP- oder ein NPN-Bipolartransistor, dessen Basis mit dem Steuersignalausgang des Mikroprozessors verbunden ist. Somit kann der Schalter bzw. Transistor auf einfache Weise per Software-Programm über den Mikroprozessor geschaltet werden, so dass eine automatische Funktionsprüfung des Inkrementalgebers zu vorgegebenen Zeitpunkten möglich ist.

Je nach Anwendungsfall können die Abschirmfläche und die Sensorflächen unterschiedlich angeordnet werden. Beispielsweise sind die Abschirmfläche und die Sensorflächen auf die Rückseite der Abdeckplatte aufgebracht, wobei die Abschirmfläche die Sensorflächen umgibt. Insbesondere können die Abschirmfläche und die Sensorflächen auf die Rückseite der Abdeckplatte aufgedampft oder aufgeklebt oder aufgedruckt sein. Alternativ dazu sind die Abschirmfläche und die Sensorflächen auf der gleichen Seite eines Trägers angeordnet, wobei die Abschirmfläche die Sensorflächen ebenfalls umgibt.

In einer weiteren Ausführungsform sind die Sensorflächen auf der Vorderseite eines Trägers und die Abschirmfläche auf der Rückseite des Trägers zumindest im Bereich der Sensorflächen angeordnet. Auf diese Weise können die Sensorflächen gegenüber rückwärtig angeordneter Leistungselektronik abgeschirmt werden, insbesondere bei einem Haushaltsgerät, wie beispielsweise einer Waschmaschine, einem Wäschetrockner, einer Geschirrspülmaschine, einem Gargerät, einer Dunstabzugshaube, einem Kältegerät, einem Klimagerät, einem Warmwasserbereiter oder einem Staubsauger. Insbesondere ist der Träger eine Leiterplatte, die einen Teilbereich der Vorderseite als Sensorflächen aufweist und deren gesamte Rückseite als Abschirmfläche ausgebildet ist.

Gemäß einer bevorzugten Ausführungsform ist der Träger in einem Abstand von der Abdeckplatte angeordnet, und zwischen Abdeckplatte und Träger ist für jede Sensorfläche ein elektrisch leitfähiger Körper angeordnet, der den Abstand überbrückt und der mit der zugehörigen Sensorfläche elektrisch leitend verbunden ist und/oder der zumindest mit einem Teil seiner Oberfläche zumindest einen Teil der Sensorfläche bildet. Durch den elektrisch leitfähigen Körper wird die sensorische Fühlereigenschaft der Sensorfläche von dem Träger an die Rückseite der Abdeckplatte verlagert. Die Abschirmfläche ist durch die Luftschicht zwischen Träger und Abdeckplatte gegenüber Ladungsänderungen an der Vorderseite der Abdeckplatte, insbesondere bei Berührung durch einen Benutzer, isoliert.

In einer anderen Ausführungsform ist der Träger eine flexible Leiterplatte oder eine kupferkaschierte Kunststofffolie. Solch ein Träger kann an Abdeckplatten verschiedenster Krümmungen angepasst werden, so dass die Sensorflächen formschlüssig an der Rückseite der Abdeckplatte anliegen. Insbesondere kann solch ein Träger an die Rückseite der Abdeckplatte angedrückt oder angeklebt werden.

In einer weiteren möglichen Ausführungsform weist der Inkrementalgeber eine Referenzsensorfläche zur Erzeugung eines Referenzsignals für eine Bestimmung eines Betätigungszustands des Inkrementalgebers auf, wobei Signalanteile des Referenzsignals proportional zur Kapazität eines mit der Referenzsensorfläche gebildeten Referenzkondensators sind, und die Kapazität des Referenzkondensators durch Umgebungsbedingungen der Sensorflächen bestimmt ist. Dies bringt den Vorteil mit sich, dass der Einfluss von Umgebungsbedingungen, wie beispielsweise Feuchtigkeit, Temperatur oder zeitliche Temperaturgradienten, aber auch der Einfluss von Materialveränderungen durch Alterung auf das Ausgangssignal der Sensorfläche durch das Referenzsignal bestimmt ist und bei der Auswertung des Ausgangssignals berücksichtigt werden kann, welches proportional zur Kapazität des mit der Sensorfläche gebildeten Kondensators ist. Ein weiterer Vorteil besteht darin, dass bei Geräten, die mit einem Netzschalter eingeschaltet werden, durch das Referenzsignal bereits beim Einschalten festgestellt werden kann, ob eine Betätigung des Inkrementalgebers vorliegt. Insgesamt können durch das Referenzsignal Plausibilitätsabfragen bei der Auswertung der Ausgangssignale reduziert werden.

In der Ausführungsform, bei der der Träger in einem Abstand von der Abdeckplatte und zwischen Abdeckplatte und Träger ein elektrisch leitfähiger Körper angeordnet ist, der den Abstand überbrückt und der mit der zugehörigen Sensorfläche elektrisch leitend verbunden ist und/oder der zumindest mit einem Teil seiner Oberfläche zumindest einen Teil der zugehörigen Sensorfläche bildet, hat es sich als besonders günstig erwiesen, auf dem Träger zumindest ein elektronisches Bauelement derart anzuordnen, dass es in einen Hohlraum ragt, der von dem elektrisch leitfähigen Körper umgeben ist. Insbesondere zusammen mit einer auf der Rückseite der Leiterplatte angeordneten Abschirmfläche bildet der elektrisch leitfähige Körper, der insbesondere eine aus einem gestreckten Körper gewundene Druckfeder ist, eine Art Faradaykäfig für das elektronische Bauelement, so dass dieses gegenüber elektromagnetischen Störsignalen der Umgebung abgeschirmt ist. Bevorzugt wird auf diese Weise der Halbleiterschalter auf dem Träger angeordnet und von elektromagnetischen Störsignalen abgeschirmt, so dass die Qualität des Ausgangssignals verbessert ist.

Vorteilhafterweise ist auf dem Träger in den von dem elektrisch leitfähigen Körper umgebenen Hohlraum ragend und/oder innerhalb eines durch die jeweilige Sensorfläche definierten Bereichs jeweils ein Leuchtelement angeordnet, wie beispielsweise eine LED, eine Glühlampe oder ein Lichtleiter. Dieses Leuchtelement kann zur Kennzeichnung der Sensorfläche oder zur Signalisierung verschiedener Schaltzustände des Inkrementalgebers dienen. Weiterhin kann zur Positionskennzeichnung der Sensorfläche an der Oberseite der Abdeckplatte oder bei durchsichtiger Abdeckplatte an deren Unterseite eine Markierung, z.B. in Form eines Aufdrucks angebracht sein.

Vorzugsweise ist ein Haushaltsgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger, bzw. ein Eingabefeld für solch ein Haushaltsgerät mit zumindest einem erfindungsgemäßen Inkrementalgeber ausgestattet. Somit kann das Haushaltsgerät mit einer das Eingabefeld umfassenden durchgängige Blende ausgestattet werden, so dass das Haushaltsgerät gegenüber einem Eintritt von Verschmutzungen oder Feuchtigkeit geschützt ist. Die Blende entspricht dabei der elektrisch isolierenden Abdeckplatte und kann beispielsweise aus Glas, Glaskeramik, Keramik, Kunststoff, Holz oder Stein gefertigt sein. Des weiteren ist durch den erfindungsgemäßen Inkrementalgeber die Gerätesicherheit gewährleistet, da das Haushaltsgerät automatisch abgeschaltet werden kann, wenn die Funktionsfähigkeit des Inkrementalgebers nicht mehr gegeben ist.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt in einer schematischen Schnittansicht einen Ausschnitt eines Haushaltsgerätes mit einer Blende, die ein erfindungsgemäßes Eingabefeld aufweist,
- Fig. 2: zeigt in einer schematischen Vorderansicht eine Ausführungsform einer Sensorfläche mit einer die Sensorfläche umrahmenden Abschirmfläche,
- Fig. 3a, 3b: zeigen schematisch einen Ausschnitt des Eingabefeldes gemäß Figur 1 mit einer Betätigung eines kapazitiven Inkrementalgebers durch einen Benutzer,
- Fig. 4: zeigt einen Ausschnitt eines schematischen elektrischen Schaltkreises des kapazitiven Inkrementalgebers,
- Fig. 5: zeigt einen Ausschnitt eines schematischen elektrischen Schaltkreises des Inkrementalgebers mit einer aktiven Abschirmung,
- Fig. 6: zeigt schematisch eine Ausführungsform des Inkrementalgebers, bei der die Sensorflächen einen linearen Berührbereich ausbilden,
- Fig. 7: zeigt schematisch eine Ausführungsform des Inkrementalgebers, bei der die Sensorflächen einen ringförmigen Berührbereich ausbilden,
- Fig. 8: zeigt einen Ausschnitt aus einer schematischen Signalfolge,
- Fig. 9: zeigt in einer schematischen Schnittansicht einen Ausschnitt des Eingabefeldes gemäß Figur 1 mit elektronischen Bauelementen des elektrischen Schaltkreises gemäß Figur 4, die in einen von einer Druckfeder umgeben Hohlraum ragen.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungsschalters gemäß der Erfindung in sämtlichen Zeichnungsfiguren durch gleiche Bezugszeichen bezeichnet sind. Werden in einer Zeichnung mehrere Elemente bzw. Einzelteile gleicher Art verwendet, auf die unterschiedlich Bezug genommen wird, so wird für die führende(n) Stelle(n) der entsprechenden Bezugszeichen jeweils die gleiche(n) Ziffer(n) gewählt. Die folgenden Stellen der entsprechenden Bezugszeichen dienen dazu, die Elemente bzw. Einzelteile gleicher Art zu unterscheiden.

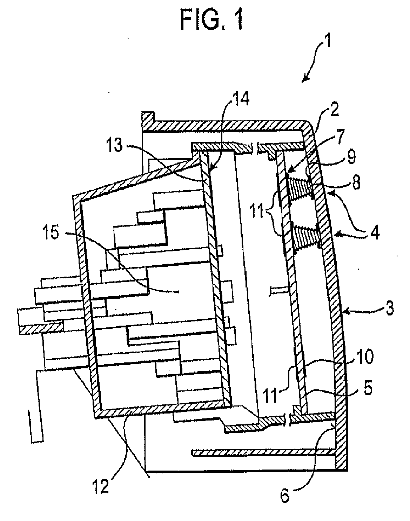

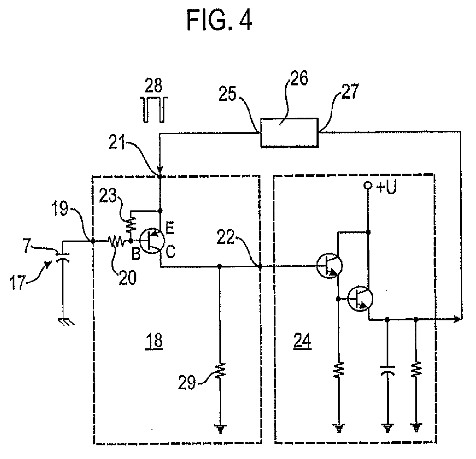

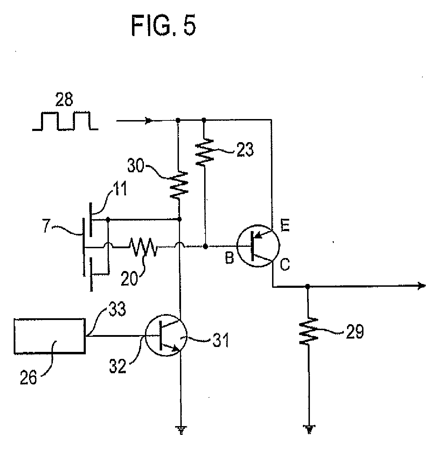

In Fig. 1 ist in einer schematischen Schnittansicht ein Ausschnitt eines Haushaltsgerätes 1 mit einer Blende 2 gezeigt, die ein erfindungsgemäßes Eingabefeld 3 aufweist. Die Blende 2 ist als elektrisch isolierende Abdeckplatte aus einem Dielektrikum, wie beispielsweise Glas, Glaskeramik, Keramik, Kunststoff, Holz oder Stein ausgebildet. Das Eingabefeld 3 enthält einen kapazitiven Inkrementalgeber 4. In einem Abstand von der Blende 2 ist eine Leiterplatte 5 mit einer Vielzahl von der Rückseite 6 der Blende 2 zugewandten elektrisch leitfähigen Sensorflächen 7 angeordnet, von denen hier nur zwei gezeigt sind und von denen im folgenden lediglich eine beschrieben wird. Die Leiterplatte 5 kann eine Kunststoffplatte sein, die auf wenigstens einer ihrer Plattenseiten die erwähnten Sensorflächen 7 und gegebenenfalls Leiterbahnen aufweist, über die die Sensorflächen 7 mit einem elektrischen Schaltkreis 14 des Inkrementalgebers 4 (siehe Fig. 4 und 5) elektrisch leitend verbunden sind. Die elektrisch leitende Schicht der Sensorfläche 7 kann jeweils in verschiedenen Formen ausgebildet sein, beispielsweise rund oder eckig, vollflächig, gitterförmig oder rahmenförmig.

Zwischen der Blende 2 und der Leiterplatte 5 ist ein elektrisch leitfähiger Körper in Form einer gewundene Druckfeder 8 angeordnet, die vorzugsweise aus Federdraht ausgebildet ist. Die Druckfeder 8 weist an ihrem oberen Ende einen flachen Windungsteller 9 auf, der aus mehrere Windungen besteht, die aufgrund einer Druckspannung, unter der die Druckfeder 8 steht, spiralförmig ineinander liegen und formschlüssig an die leicht gewölbte Form der Rückseite 6 der Blende 2 angepasst sind. Die Druckfeder 8 weist an ihrem unteren Ende eine untere Windung 9' auf, mit der sie an der Sensorfläche 7 der Leiterplatte 5 plan anliegt und dort mit der Sensorfläche 7 der Leiterplatte 5 beispielsweise verlötet oder verklebt ist, oder mit der sie an der Sensorfläche 7 der Leiterplatte 5 lediglich unter Druckspannung fest anliegt, so dass eine elektrisch leitende Verbindung zwischen der Druckfeder 8 und der Sensorfläche 7 der Leiterplatte 5 besteht. Durch diese elektrisch leitende Verbindung ist die sensorische Fühlereigenschaft der Sensorfläche 7 von der Leiterplatte 5 an die Rückseite 6 der Blende 2 verlagert und die Druckfeder 8 bildet nun ihrerseits zumindest einen Teil der Sensorfläche 7, insbesondere mit ihrem Windungsteller 9, 9'. Anstatt als gewundene, metallische Druckfeder 8 kann der elektrisch leitfähige Körper auch andere Formen aufweisen, wie beispielsweise zylinder- , kegel- oder quaderförmig, und/oder aus anderen, elektrisch leitfähigen Materialien ausgebildet sein, wie beispielsweise aus einem elektrisch leitfähigen Kunststoff oder aus einem Kunststoff mit metallischer Seele.

Auf der gleichen Seite der Leiterplatte 5, auf der sich die Sensorflächen 7 befinden, also auf der der Rückseite 6 der Blende 2 zugewandten Vorderseite der Leiterplatte 5, ist eine elektrisch leitfähigen Referenzsensorfläche 10 angeordnet. Die Referenzsensorfläche 10 ist analog zu der Sensorfläche 7 mit dem Schaltkreis 14 des Inkrementalgebers 4 elektrisch leitend verbunden. Im Unterschied zu der Sensorfläche 7 fehlt bei der Referenzsensorfläche 10 die elektrisch leitfähige Druckfeder 8, so dass die Referenzsensorfläche 10 durch die Luftschicht zwischen der Leiterplatte 5 und der Blende 2 gegenüber elektrischen Ladungen bzw. Ladungsänderungen an der Vorderseite der Blende 2 elektrisch isoliert ist.

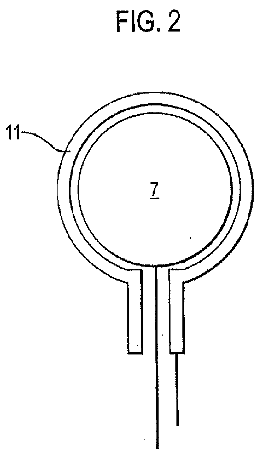

Auf der Rückseite der Leiterplatte 5 ist an der Position der Sensorfläche 7 bzw. der Referenzsensorfläche 10 jeweils eine elektrisch leitende Abschirmfläche 11 angeordnet, deren Funktionsweise weiter unten in Figur 5 beschrieben wird. Anstelle von einzelnen Abschirmflächen 11 je Sensorfläche 7 bzw. Referenzsensorfläche 10 kann eine einzige Abschirmfläche vorgesehen sein, die sich über die gesamte Rückseite der Leiterplatte 5 erstreckt oder die zumindest auf der Rückseite der Leiterplatte 5 den Bereich abdeckt, der die Sensorflächen 7 bzw. die Referenzsensorfläche 10 umfasst. Insbesondere kann die Leiterplatte 5 eine flexible Leiterplatte oder eine kupferkaschierte Kunststofffolie sein. In einer weiteren alternative Ausführungsform, die in Figur 2 gezeigt ist, befinden sich die Sensorfläche 7, die hier rund ausgeführt ist, und die Abschirmfläche 11 beide auf der Vorderseite der Leiterplatte 5. Die Abschirmfläche 11 wird hier durch einen elektrisch leitfähige Schicht gebildet, die die Sensorfläche 7 rahmenförmig umgibt, wobei die Form dieses Rahmens der Außenkontur der Sensorfläche 7 angepasst ist.

Der elektrische Schaltkreis 14 des Inkrementalgebers 4 kann auf der Vorder- oder Rückseite der Leiterplatte 5 oder auf einer separaten Platine angeordnet sein. Des weiteren kann für mehrere oder alle Sensorflächen 7 des Inkrementalgebers 4 ein gemeinsamer Schaltkreis 14 vorgesehen sein. In der in Figur 1 gezeigten Ausführungsform ist im rückwärtigen Bereich der Leiterplatte 5 ein Elektronikmodul 12 angeordnet, das eine Platine 13 aufweist, die auf ihrer der Leiterplatte 5 zugewandten Vorderseite den Schaltkreis 14 des Inkrementalgebers 4 aufweist und die auf ihrer Rückseite mit Leistungselektronik 15 des Haushaltsgerätes 1 bestückt ist. Diese Platine 13 ist mit der Leiterplatte 5 elektrisch leitend verbunden (nicht gezeigt).

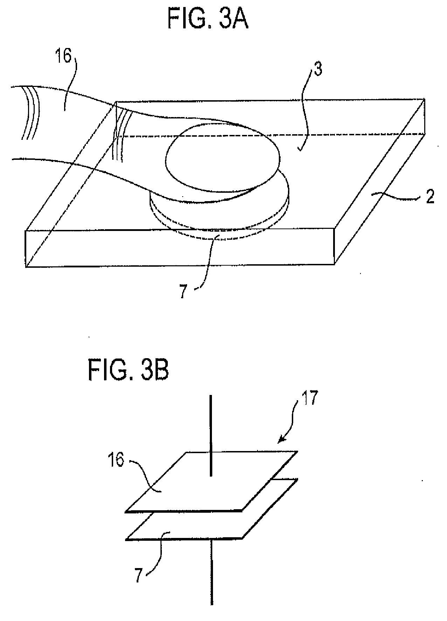

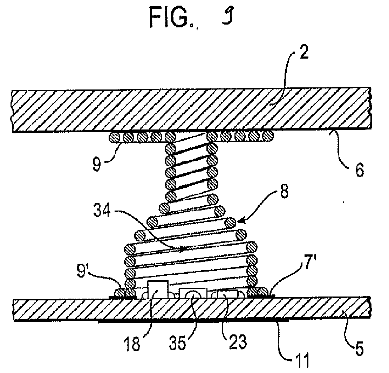

Wird nun wie in Figur 3a gezeigt ein Element, wie beispielsweise ein Finger 16 eines Benutzers, das bzw. der ein vom Potenzial der Sensorfläche 7 verschiedenes Potenzial, insbesondere Erdpotenzial führt, an einen der Sensorfläche 7 gegenüberliegenden Oberflächenbereich der Blende 2 angenähert und/oder mit diesem in Berührung gebracht, so wird dadurch eine Kapazitätsänderung eines aus dem betreffenden Element bzw. dem Finger 16, der Blende 2 und der Sensorfläche 7 bzw. der Sensorfläche 7 zusammen mit der Druckfeder 8 bestehenden Kondensators 17 hervorgerufen (vgl. Fig. 3b). Da die Sensorfläche 7 elektrisch leitend mit dem Schaltkreis 14 des Inkrementalgebers 4 verbunden ist, kann die Kapazitätsänderung durch den Schaltkreis 14 festgestellt und zur Auslösung eines Schaltsignals weiter ausgewertet werden, wie weiter unten beschrieben. Des weiteren kann auf der Leiterplatte 5 im Bereich innerhalb der Druckfeder 8 eine Lichtquelle 35 (vgl. Fig. 9), wie beispielsweise eine LED, vorgesehen sein, um die Sensorfläche 7 zu kennzeichnen oder unterschiedliche Schaltzustände des Inkrementalgebers 4 zu signalisieren.

In Figur 4 ist ein Ausschnitt eines Schaltbildes des elektrischen Schaltkreises 14 gezeigt. Der Schaltkreis 14 weist als Halbleiterschalter 18 einen PNP-Bipolartransistor auf, mit dessen Steuereingang 19, also mit dessen Basis, die Sensorfläche 7 über einen Strombegrenzungswiderstand 20 verbunden ist. Der Halbleiterschalter 18 weist darüber hinaus einen Signaleingang 21, d.h. den Emitter des PNP-Bipolartransistors, und einen Signalausgang 22, d.h. den Kollektor des PNP-Bipolartransistors, auf, wobei der Signaleingang 21 über einen Basis-Emitter-Widerstand 23 mit der Sensorfläche 7 verbunden ist. Der Strombegrenzungswiderstand 20 und der Basis-Emitter-Widerstand 23 können in dem PNP-Bipolartransistor bereits integriert ausgeführt sein. Der Signalausgang 22 des Halbleiterschalters 18 ist zur weiteren Verarbeitung eines Ausgangssignals mit einer Sample and Hold-Stufe 24 bekannter Art verbunden, durch die ein Gleichspannungssignal proportional zur Amplitude der Impulsspitzen des Ausgangssignals zur Verfügung gestellt werden kann und die hier nicht weiter beschrieben wird. Alternativ zu der Sample and Hold-Stufe 24 kann der Signalausgang 22 des Halbleiterschalters 18 zur Verarbeitung des Ausgangssignals mit einer bekannten Integratorschaltung oder einem bekannten Spitzenspannungsmesser verbunden sein (nicht gezeigt). Der Signaleingang 21 des Halbleiterschalters 18 ist mit einem analogen Signalausgang 25 eines Mikroprozessors 26 und der Signalausgang 22 des Halbleiterschalters 18 ist über die Sample and Hold-Stufe 24 mit einem analogen Signaleingang 27 des Mikroprozessors 26 verbunden. Anstelle des einen Mikroprozessors 26 können auch zwei verschiedene Mikroprozessoren verwendet werden, von denen einer mit dem Signaleingang 21 des Halbleiterschalters 18 und der andere mit dem Signalausgang 22 des Halbleiterschalters 18 verbunden ist. Anstelle des PNP-Bipolartransistors können auch andere Halbleiterschalter 18 verwendet werden, wie beispielsweise ein NPN-Bipolartransistor, Feldeffekttransistoren oder allgemein alle steuerbaren Halbleiterelemente.

An dem Signaleingang 21 des Halbleiterschalters 18 liegt ein Taktsignal 28 an, welches beispielsweise von dem analogen Signalausgang 25 des Mikroprozessors 26 zur Verfügung gestellt wird. Das Taktsignal 28 ist ein rechteckförmiges, periodisches Spannungssignal, welches von dem Mikroprozessor 26 regelmäßig zwischen Massepotenzial, d.h. LOW-Pegel, und Betriebsspannung des Schaltkreises 14 des Annäherungsschalters 4, d.h. HIGH-Pegel, umgeschaltet wird, wobei das Massepotenzial von dem Erdpotenzial des Benutzers verschieden sein kann. Die Taktfrequenz des Taktsignals 28 liegt bevorzugt im Bereich zwischen 10 und 100 Kilohertz. Der Signalausgang 22 des Halbleiterschalters 18, also der Kollektor des PNP-Bipolartransistors, liegt über einen weiteren Widerstand 29 auf dem Bezugspotenzial der Sample and Hold-Stufe 24. Mit dem LOW-Pegel des Taktsignals 28 wird der Signaleingang 21 des Halbleiterschalters 18 und damit der Emitter E des PNP-Bipolartransistors sowie der Basis-Emitter-Widerstand 23 auf Massepotenzial gelegt. Dies führt dazu, dass die Sensorfläche 7 bzw. der Kondensator 17 über den Strombegrenzungswiderstand 20 und den Basis-Emitter-Widerstand 23 entladen wird. Dadurch wird die Basis B des PNP-Bipolartransistors gegenüber dem Emitter E des PNP-Bipolartransistors positiv und der PNP-Bipolartransistors sperrt. Mit dem auf den LOW-Pegel folgenden HIGH-Pegel des Taktsignals 28 wird die Sensorfläche 7 und damit der Kondensator 17 über den Basis-Emitterwiderstand 23 und den Strombegrenzungswiderstand 20 aufgeladen. Während dieser Aufladezeit der Sensorfläche 7 bzw. des Kondensators 17 besteht ein Spannungsabfall an dem Basis-Emitter-Widerstand 23. Dadurch wird die Basis B des PNP-Bipolartransistors gegenüber dem Emitter E negativ und der PNP-Bipolartransistor wird leitend und schaltet so lange durch, bis die Sensorfläche 7 bzw. der Kondensator 17 auf den HIGH-Pegel des Taktsignals 28 aufgeladen ist. An dem Widerstand 29 liegt während dieses Aufladezeitraums der Sensorfläche 7 bzw. des Kondensators 17 durch das Taktsignal 28 ein Ausgangssignal an, das proportional zu der Kapazität der Sensorfläche 7 bzw. des Kondensators 17 ist. Somit liegt an dem Signalausgang 22 des Halbleiterschalters 18 ein Ausgangsignal an, welches dem Taktsignal 28 folgt, und dessen Signalanteile proportional zu der Kapazität der Sensorfläche 7 bzw. des Kondensators 17 sind.

Dieses Ausgangssignal wird mittels der Sample and Hold-Stufe in ein Gleichspannungssignal umgewandelt und liegt an dem analogen Signaleingang 27 des Mikroprozessors 26 an. Der Mikroprozessor 26 ist zur Auswertung einer zeitlichen Änderung von Signalanteilen des Gleichspannungssignals und damit des Ausgangssignals beispielsweise mit Hilfe eines Software-Programms ausgebildet. Abhängig davon, wie schnell die Signalanteile des Ausgangssignals, wie beispielsweise die Höhe der Impulsspitze oder die Impulsbreite, von aufeinander folgenden Taktperioden sich ändern, wird von dem Mikroprozessor 26 eine Betätigung des Inkrementalgebers 4 erkannt. D.h. ändern sich die Signalanteile innerhalb eines vorgegebenen Zeitraums von beispielsweise einer Sekunde, so wird dies als Betätigung erkannt, ändern sich die Signalanteile langsamer, so liegt keine Betätigung vor. Auf diese Weise ist die Bestimmung einer Betätigung des Inkrementalgebers 4 unabhängig von der absoluten Größe des Ausgangssignals, wodurch dessen langfristige Änderungen, z.B. durch Alterungsprozesse, eliminiert sind.

In Figur 5 ist ein Ausschnitt des elektrischen Schaltkreises 14 des erfindungsgemäßen Inkrementalgebers 4 mit einer aktiven Abschirmung gezeigt. Die aktive Abschirmung ist durch die Abschirmfläche 11 gebildet, die über einen niederohmigen Widerstand 30 mit dem Signaleingang 21 des Halbleiterschalters 18 verbunden ist, und an der zeitgleich zu der Sensorfläche 7 das Taktsignal 28 über diesen niederohmigen Widerstand 30 anliegt. Durch geeignete Wahl des niederohmigen Widerstands 30 kann die Signalform des Taktsignals 28 an der Abschirmfläche 11 an die Signalform des Taktsignals 28 an der Sensorfläche 7 angeglichen werden, so dass kein Potenzialunterschied und damit keine Verschiebung von Ladungsträgern zwischen der Abschirmfläche 11 und der Sensorfläche 7 auftritt und somit die Abschirmung der Sensorfläche 7 durch die Abschirmfläche 11 gegenüber Störkapazitäten gewährleistet ist.

Die Abschirmfläche 11 ist zum Anlegen von Massepotenzial über einen Schalter 31, der in der hier gezeigten Ausführungsform ein NPN-Bipolartransistor ist, mit Masse verbunden. Der Schalter 31 weist einen Steuersignaleingang 32 auf, nämlich die Basis des NPN-Bipolartransistors, der mit einem Steuersignalausgang 33 des Mikroprozessors 26 verbunden ist. Somit kann der Schalter 31 bzw. der NPN-Bipolartransistor auf einfache Weise durch ein Software-Programm des Mikroprozessors 26 geschaltet werden. Zur Funktionsprüfung des Inkrementalgebers 4, d.h. zur Ermittlung eines Referenzwertes des Ausgangssignals wird die Abschirmfläche 11 durch den Schalter 31 zeitweise mit Massepotenzial verbunden, wodurch die aktive Abschirmung zeitweise außer Kraft gesetzt und eine Betätigung des Inkrementalgebers 4 simuliert wird. Auf diese Weise kann überprüft werden, ob ein ausreichender Signalhub des Ausgangssignals bei Betätigung des Inkrementalgebers 4 vorliegt, oder ob eventuell aufgrund von Verunreinigungen oder Benetzung der Blende 2, aufgrund von Umgebungsbedingungen, wie Temperatur und Feuchtigkeit, oder aufgrund von Alterungsprozessen des Inkrementalgebers 4 eine Fehlfunktion vorliegt. Eventuell kann der Signalhub des Ausgangssignals durch Änderung der Höhe des Taktsignals 28 dynamisch angepasst werden, d.h. der Inkrementalgeber 4 kann automatisch kalibriert werden, wodurch die Funktionssicherheit des Inkrementalgebers 4 verbessert wird. Wenn aufgrund beispielsweise einer verschmutzten Blende 2 eine sichere Funktion des Inkrementalgebers 4 nicht mehr gewährleistet ist, wird das Haushaltsgerät 1 automatisch abgeschaltet.

Die Referenzsensorfläche 10 ist entsprechend den Sensorflächen 7 verschaltet. Die Referenzsensorfläche 10 ist benachbart zu den Sensorflächen 7 angeordnet, so dass die Kapazität der Referenzsensorfläche 10 bzw. eines mit der Referenzsensorfläche 10 gebildeten offenen Referenzkondensators ein Maß für die Umgebungsbedingungen, d.h. die Störkapazitäten, der Sensorflächen 7, aber auch ein Maß für den Einfluss von Temperatur, Feuchtigkeit oder von Materialveränderungen durch Alterung auf das Ausgangssignal ist. An der Referenzsensorfläche 10 liegt das gleiche Taktsignal 28 wie an den Sensorflächen 7 an, insbesondere in einem zeitlichen Multiplexverfahren. D.h. die Sensorflächen 7 und die Referenzsensorfläche 10 werden nacheinander mit verschiedene Perioden des gleichen Taktsignals 28 versorgt. Alternativ dazu kann an die Referenzsensorfläche 10 auch ein weiteres Taktsignal von einem weiteren analogen Signalausgang des Mikroprozessors 26 angelegt werden. Das von der Referenzsensorfläche 10 erzeugte Referenzsignal wird bei der Auswertung des von der Sensorfläche 7 erzeugten Ausgangssignals in dem Mikroprozessor 26 als Grundpegel des Ausgangssignals berücksichtigt, und dient somit der Bestimmung eines Betätigungszustands des Inkrementalgebers 4. Bei Haushaltsgeräten 1, die mit einem Netzschalter eingeschaltet werden, wird mit Hilfe des Referenzsignal bereits beim Einschalten festgestellt, ob eine Betätigung des Inkrementalgebers 4 vorliegt.

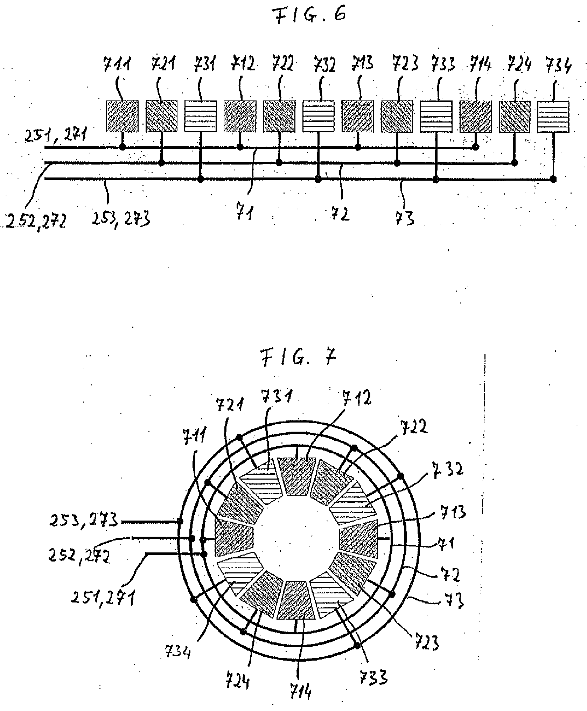

In Figur 6 und Figur 7 sind schematisch zwei Ausführungsformen des Inkrementalgebers 4 mit jeweils zwölf Sensorflächen 711, 721, 731, 712, 722, 732, 713, 723, 733, 714, 724 und 734 gezeigt. In Figur 6 bilden diese Sensorflächen 711, 721, 731, 712, 722, 732, 713, 723, 733, 714, 724 und 734 einen linearen Berührbereich und in Figur 7 einen ringförmigen Berührbereich. Die Sensorflächen 711, 712, 713 und 714 sind miteinander elektrisch leitend zu einer ersten Gruppe 71 verbunden, die Sensorflächen 721, 722, 723 und 724 sind miteinander elektrisch leitend zu einer zweiten Gruppe 72 verbunden und die Sensorflächen 731, 732, 733 und 734 sind miteinander elektrisch leitend zu einer dritten Gruppe 73 verbunden. Die Sensorflächen 7ij sind derart alternierend nebeneinander angeordnet, dass jeweils zwischen zwei Sensorflächen 7ij, 7i(j+1) einer Gruppe 7i je eine Sensorfläche 7kl, 7mn von jeder der beiden anderen Gruppen 7k, 7m angeordnet ist.

Die erste Gruppe 71 ist mit einem ersten Signalausgang 251, die zweite Gruppe 72 mit einem zweiten Signalausgang 252 und die dritte Gruppe 73 mit einem dritten Signalausgang 253 des Mikroprozessors 26 verbunden. Somit kann an die Gruppen 71, 72 oder 73 das Spannungssignal 28 in einem zeitlichen Multiplexverfahren angelegt werden. Zusätzlich ist jede der Gruppe 71, 72 bzw. 73 über ihren jeweils zugehörigen Halbleiterschalter 18 und eventuell eine zugehörige Sample and Hold Stufe 24 mit je einem Signaleingang 271, 272 oder 273 des Mikroprozessors 26 verbunden. Das Taktsignal 28 wird jeweils für eine vorgegebene Zeitdauer, d.h. für eine vorgegebene Anzahl an Taktperioden, von einem der drei Signalausgängen 25 des Mikroprozessors 26 ausgegeben. Dabei wechseln sich die Signalausgänge 251, 252 und 253 nacheinander ab, was zyklisch wiederholt wird. In der Zeitdauer, in der das Taktsignal 28 von einem der drei Signalausgänge 251, 252 und 253 ausgegeben wird, wird jeweils der entsprechende der drei Signaleingänge 271, 272 und 273 des Mikroprozessors 26 ausgewertet. Es ist alternativ auch möglich, dass alle drei Gruppen 71, 72 und 73 mit demselben Signalausgang 25 des Mikroprozessors verbunden sind, so dass das Taktsignal 28 gleichzeitig an allen drei Gruppen 71, 72 und 73 anliegt. In diesem Fall werden in der Zeitdauer, in der das Taktsignal 28 von dem Signalausgang 25 ausgegeben wird, nacheinander die drei Signaleingänge 271, 272 und 273 des Mikroprozessors ausgewertet.

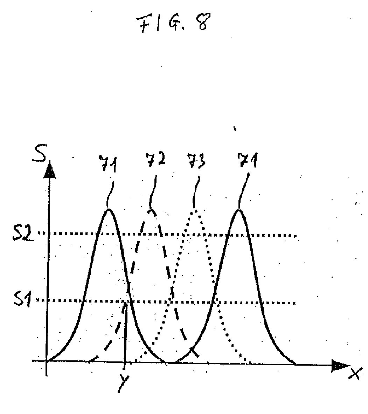

In Figur 8 ist schematisch eine Abfolge der Ausgangssignale S der drei Gruppen 71, 72 und 73 gezeigt, die auftritt, wenn der Benutzer beispielsweise mit einem Finger in einer Richtung x von links nach rechts über die lineare Berührfläche gemäß Figur 6 oder im Uhrzeigersinn über die ringförmige Berührfläche gemäß Figur 7 streicht. Überschreitet das Ausgangssignal einer der Gruppen 71, 72 oder 73 eine erste Signalschwelle S1, so wird das als ein Schritt des Inkrementalgebers 4 gezählt. Überschreitet das gleiche Ausgangssignal S daraufhin eine zweite Signalschwelle S2, so wird dies als Folgeschritt des Inkrementalgebers 4 gezählt. Um bei Überschreiten der ersten Signalschwelle S1 durch eines der Ausgangssignale S einer der Gruppen 71, 72 oder 73 zu bewerten, ob tatsächlich eine Betätigung des Inkrementalgebers 4 vorliegt, wird das kumulierte Signal aus den Ausgangssignalen S aller drei Gruppen 71, 72 und 73 ausgewertet. Beispielsweise setzt sich bei Überschreiten der ersten Signalschwelle S1 durch das Ausgangssignal S der zweiten Gruppe 72 an der Position y das kumulierte Signal im wesentlichen aus dem Ausgangssignal der ersten Gruppe 71 und der zweiten Gruppe 72 zusammen.

In Figur 9 ist in einer schematischen Schnittansicht ein Ausschnitt des Eingabefeldes gemäß Figur 1 gezeigt. Auf der Leiterplatte 5 ist ein Lötring 7' aufgebrachte, mit dem der durch die unteren zwei Windungen der gewundenen Druckfeder 8 gebildete Windungsteller 9' mit der Leiterplatte 5 verlötet und auf diese Weise mit dem elektrischen Schaltkreis 14 verbunden ist. Die Druckfeder 8 umschließt mit ihren Windungen einen Hohlraum 34. Auf der Leiterplatte 5 sind innerhalb des Lötrings 7' auf der der Abdeckplatte 2 zugewandten Seite von den elektronischen Bauteilen des elektrischen Schaltkreises 14 der PNP-Bipolartransistor des Halbleiterschalters 18, mit seinem Basis-Emitter-Widerstand 23 und seinem Strombegrenzungswiderstand 20 sowie eine Leuchtdiode 35 angeordnet, die in den von der Druckfeder 8 umschlossenen Hohlraum 34 ragen. Um eine elektrische Verbindung dieser elektronischen Bauteile mit den weiteren Bauteilen des elektrischen Schaltkreises 14 zu ermöglichen, ist der Lötring 7' kein gänzlich geschlossener Ring, sondern seitlich unterbrochen (nicht gezeigt). Alternativ dazu kann die elektrische Verbindung auch durch die Leiterplatte 5 hindurch erfolgen. Zusammen mit der auf der Rückseite der Leiterplatte 5 angeordneten Abschirmfläche 11 bildet die Druckfeder 8 einen Faradaykäfig für die im Innenbereich 34 der Druckfeder 8 angeordneten elektronischen Bauteile, so dass diese gegenüber elektromagnetischen Feldern der Umgebung abgeschirmt sind.

### Bezugszeichenliste

- 1: Haushaltsgerät
- 2: Blende
- 3: Eingabefeld
- 4: Inkrementalgeber
- 5: Leiterplatte
- 6: Rückseite der Blende
- 7: Sensorfläche
- 7': Lötring
- 8: Druckfeder
- 9: Windungsteller der oberen Windungen
- 9': Windungsteller der unteren Windungen
- 10: Referenzsensorfläche
- 11: Abschirmfläche
- 12: Elektronikmodul
- 13: Platine
- 14: Schaltkreis des Inkrementalgebers
- 15: Leistungselektronik
- 16: Finger des Benutzers
- 17: Kondensator
- 18: Halbleiterschalter
- 19: Steuereingang des Halbleiterschalters
- 20: Strombegrenzungswiderstand
- 21: Signaleingang des Halbleiterschalters
- 22: Signalausgang des Halbleiterschalters
- 23: Basis-Emitter-Widerstand
- 24: Sample and Hold-Stufe
- 25: Analoger Signalausgang des Mikroprozessors
- 26: Mikroprozessor
- 27: Analoger Signaleingang des Mikroprozessors
- 28: Taktsignal
- 29: Widerstand
- 30: Niederohmiger Widerstand
- 31: Schalter
- 32: Steuersignaleingang des Schalters
- 33: Steuersignalausgang des Mikroprozessors
- 34: von der Druckfeder umschlossener Hohlraum
- 35: Leuchtdiode
- 71: erste Gruppe der Sensorflächen
- 72: zweite Gruppe der Sensorflächen
- 73: dritte Gruppe der Sensorflächen
- S: Ausgangssignal
- S1: erste Signalschwelle
- S2: zweite Signalschwelle
- x: Richtung der Berührbewegung
- y: Berührposition

## Patentansprüche

1. Kapazitiver Inkrementalgeber mit zumindest drei Gruppen (71, 72, 73) von einzelnen Sensorflächen (7, 7ij), wobei alle Sensorflächen (7i1, 7i2, 7i3, 7i4) derselben Gruppe (7i) miteinander elektrisch leitend verbunden sind, wobei die Sensorflächen (7, 7ij) von einer elektrisch isolierenden Abdeckplatte (2) abgedeckt sind und Teile von Kondensatoren mit durch Berührung der Abdeckplatte (2) veränderlicher Kapazität sind, wobei jeweils zwischen zwei Sensorflächen (7ij, 7i(j+1)) derselben Gruppe (7i) je eine Sensorfläche (7kj, 7mj) von jeder der anderen Gruppen (7k, 7m)angeordnet ist, wobei jede Gruppe (71, 72, 73) derart mit einer Spannungsquelle (25) elektrisch leitend verbunden ist, so dass an jede Gruppe (71, 72, 73) ein Spannungssignal anlegbar ist, und wobei jede Gruppe (71, 72, 73) derart mit einer Auswerteschaltung (14) verbunden ist, so dass für jede Gruppe (71, 72, 73) je ein Ausgangssignal (S) auswertbar ist, wobei zur Auslösung eines Schrittes des Inkrementalgebers (4) eine erste Signalschwelle (S1) für das Ausgangssignal (S) vorgesehen ist, **dadurch gekennzeichnet, dass** zur Auslösung eines Folgeschrittes des Inkrementalgebers (4) eine zweite Signalschwelle (S2) für das Ausgangssignal (S) vorgesehen ist, und dass ein Schritt des Inkrementalgebers (4) mit einer vorgegebenen Schrittweite gezählt wird, sobald das Ausgangssignal (S) einer Gruppe (7i) von Sensorflächen (7ij) die erste Signalschwelle (S1) überschreitet und ein Folgeschritt gezählt wird, sobald dasselbe Ausgangssignal (S) die zweite Signalschwelle (S2) überschreitet.

2. Inkrementalgeber nach Anspruch 1, **dadurch gekennzeichnet, dass** eine Betätigung des Inkrementalgebers (4) aus den kumulierten Ausgangssignalen der verschiedenen Gruppen (71, 72, 73) bestimmbar ist.

3. Inkrementalgeber nach Anspruch 1 oder 2, **dadurch gekennzeichnet, dass** das Spannungssignal ein Taktsignal ist.

4. Inkrementalgeber nach Anspruch 3, **dadurch gekennzeichnet, dass** die Sensorflächen (7ij) einer Gruppe (7i) jeweils mit einem Steuereingang (19) eines Halbleiterschalters (18) verbunden sind, der außerdem einen Signaleingang (21) mit dem Taktsignal (28) und einen Signalausgang (22) hat, und dass an dem Signalausgang (22) des Halbleiterschalters (18) das dem Taktsignal (28) folgende Ausgangssignal anliegt, mit Signalanteilen, die proportional zur Kapazität der mit den Sensorflächen (7ij) der Gruppe (7i) gebildeten Kondensatoren (17) sind.

5. Inkrementalgeber nach Anspruch 4, **dadurch gekennzeichnet, dass** der Steuereingang (19) zur Versorgung der Sensorflächen (7, 7ij) mit dem Taktsignal (28) ausgebildet ist, und dass das Ausgangssignal während eines Aufladezeitraums des Kondensators (17) durch das Taktsignal am Signalausgang (22) des Halbleiterschalters (18) anliegt.

6. Inkrementalgeber nach Anspruch 4 oder 5, **dadurch gekennzeichnet, dass** der Halbleiterschalter (18) einen Transistor aufweist, und die Sensorflächen (7, 7ij) mit der Basis des Transistors verbunden sind.

7. Inkrementalgeber nach einem der Ansprüche 4 bis 6, **dadurch gekennzeichnet, dass** zur Versorgung mit dem Taktsignal (28) der Signaleingang (21) mit einem Ausgang (25) eines Mikroprozessors (26) verbunden ist.

8. Inkrementalgeber nach einem der Ansprüche 3 bis 7, **dadurch gekennzeichnet, dass** das Taktsignal (28) ein periodisches Taktsignal ist, insbesondere ein Rechtecksignal.

9. Inkrementalgeber nach einem der Ansprüche 3 bis 8, **dadurch gekennzeichnet, dass** die Sensorflächen (7) jeweils eine aktive Abschirmung aufweisen und dass die aktive Abschirmung durch eine Abschirmfläche (11) gebildet ist, an der zeitgleich mit den Sensorflächen (7) das Taktsignal (28) anliegt.

10. Inkrementalgeber nach Anspruch 9, **dadurch gekennzeichnet, dass** die Sensorflächen (7) auf der Vorderseite eines Trägers (5) und die Abschirmfläche (11) auf der Rückseite des Trägers (5) zumindest im Bereich der Sensorflächen (7) angeordnet ist.

11. Inkrementalgeber nach Anspruch 10, **dadurch gekennzeichnet, dass** der Träger (5) in einem Abstand von der Abdeckplatte (2) angeordnet ist, und dass zwischen Abdeckplatte (2) und Träger (5) für jede der Sensorflächen () ein elektrisch leitfähiger Körper (8) angeordnet ist, der den Abstand überbrückt und der mit der jeweiligen Sensorfläche (7) elektrisch leitend verbunden ist und/oder der zumindest mit einem Teil seiner Oberfläche zumindest einen Teil der jeweiligen Sensorfläche (7) bildet.

12. Inkrementalgeber nach Anspruch 11, **dadurch gekennzeichnet, dass** auf dem Träger (5) zumindest ein elektronisches Bauelement (18, 20, 23, 35) derart angeordnet ist, dass es in einen Hohlraum ragt, der von dem elektrisch leitfähigen Körper (8) umgeben ist.

13. Inkrementalgeber nach Anspruch 12, **dadurch gekennzeichnet, dass** das elektronische Bauelement der Halbleiterschalter (18, 20, 23) und/oder ein Leuchtelement (35) ist.

14. Inkrementalgeber nach Anspruch 11 oder 12, **dadurch gekennzeichnet, dass** der elektrisch leitfähige Körper (8) eine aus einem gestreckten Körper gewundene Druckfeder ist.

15. Inkrementalgeber nach einem der vorhergehenden Ansprüche, **dadurch gekennzeichnet, dass** die verschiedenen Gruppen (7i) der Sensorflächen (7ij) in einem zeitlichen Multiplexverfahren geschaltet sind.

16. Inkrementalgeber nach einem der vorhergehenden Ansprüche, **dadurch gekennzeichnet, dass** die Sensorflächen (7ij) geradlinig oder bogenförmig oder ringförmig angeordnet sind.

17. Eingabefeld für ein Haushaltsgerät mit zumindest einem Inkrementalgeber (4) nach einem der Ansprüche 1 bis 16.

18. Haushaltsgerät mit einem Eingabefeld (3) nach Anspruch 17.

## Claims

1. Capacitive incremental encoder with at least three groups (71, 72, 73) of individual sensor surfaces (7, 7ij), wherein all sensor surfaces (7i1, 7i2, 7i3, 7i4) of the same group (7i) are connected to one another in an electrically conductive manner, wherein the sensor surfaces (7, 7ij) are covered by an electrically insulating cover plate (2) and parts of capacitors have a capacity which can be changed by touching the cover plate (2), wherein between two sensor surfaces (7ij, 7i(j+1)) of the same group (7i) in each case there is arranged one sensor surface (7kj, 7mj) of each of the other groups (7k, 7m), wherein each group (71, 72, 73) is connected to a voltage source (25) in an electrically conductive manner such that a voltage signal can be applied to each group (71, 72, 73), and wherein each group (71, 72, 73) is connected to an evaluation circuit (14) such that an output signal (S) can be evaluated for each group (71, 72, 73) in each case, wherein to trigger a step of the incremental encoder (4) a first signal threshold (S1) is provided for the output signal (S), **characterised in that** to trigger a subsequent step of the incremental encoder (4) a second signal threshold (S2) is provided for the output signal (S), and that a step of the incremental encoder (4) with a predefined step threshold is counted as soon as the output signal (S) of a group (7i) of sensor surfaces (7ij) exceeds the first signal threshold (S1) and a subsequent step is counted as soon as the same output signal (S) exceeds the second signal threshold (S2).

2. Incremental encoder according to claim 1, **characterised in that** an actuation of the incremental encoder (4) can be determined from the cumulative output signals of the different groups (71, 72, 73).

3. Incremental encoder according to claim 1 or 2, **characterised in that** the voltage signal is a clock signal.

4. Incremental encoder according to claim 3, **characterised in that** the sensor surfaces (7ij) of a group (7i) are each connected to a control input (19) of a semiconductor switch (18), which additionally has a signal input (21) with the clock signal (28) and a signal output (22), and that the output signal following the clock signal (28) is in contact with the signal output (22) of the semiconductor switch (18), with signal components which are proportional to the capacitance of the capacitors (17) formed with the sensor surfaces (7ij) of the group (7i).

5. Incremental encoder according to claim 4, **characterised in that** the control input (19) is designed to supply the sensor surfaces (7, 7ij) with the clock signal (28), and that the output signal is in contact with the signal output (22) of the semiconductor switch (18) during a charging time period of the capacitor (17) by the clock signal.

6. Incremental encoder according to claim 4 or 5, **characterised in that** the semiconductor switch (18) has a transistor, and the sensor surfaces (7, 7ij) are connected to the base of the transistor.

7. Incremental encoder according to one of claims 4 to 6, **characterised in that** the signal input (21) is connected to an output (25) of a microprocessor (26) in order to be supplied with the clock signal (28).

8. Incremental encoder according to one of claims 3 to 7, **characterised in that** the clock signal (28) is a periodic clock signal, in particular a rectangular signal.

9. Incremental encoder according to one of claims 3 to 8, **characterised in that** the sensor surfaces (7) each have an active shielding and that the active shielding is formed by a shield surface (11), on which the clock signal (28) is simultaneously in contact with the sensor surfaces (7).

10. Incremental encoder according to claim 9, **characterised in that** the sensor surfaces (7) is arranged on the front side of a substrate (5) and the shield surface (11) is arranged on the rear side of the substrate (5), at least in the region of the sensor surfaces (7).

11. Incremental encoder according to claim 10, **characterised in that** the substrate (5) is arranged at a distance from the cover plate (2), and that an electrically conductive element (8) is arranged between cover plate (2) and substrate (5) for each of the sensor surfaces (), which element (8) bridges the distance and which is connected to the respective sensor surface (7) in an electrically conductive manner and/or which forms at least a part of the respective sensor surface (7) at least with a part of its surface.

12. Incremental encoder according to claim 11, **characterised in that** at least one electronic component (18, 20, 23, 35) is arranged on the substrate (5) such that it protrudes into a cavity which is enclosed by the electrically conductive element (8).

13. Incremental encoder according to claim 12, **characterised in that** the electronic component is the semiconductor switch (18, 20, 23) and/or a lighting element (35).

14. Incremental encoder according to claim 11 or 12, **characterised in that** the electrically conductive element (8) is a compression spring wound from a stretched element.

15. Incremental encoder according to one of the preceding claims, **characterised in that** the different groups (7i) of the sensor surfaces (7ij) are switched in a temporal multiplex method.

16. Incremental encoder according to one of the preceding claims, **characterised in that** the sensor surfaces (7ij) are arranged in a straight line or in a curved shape or in a circular shape.

17. Input field for a domestic appliance with at least one incremental encoder (4) according to one of claims 1 to 16.

18. Domestic appliance with an input field (3) according to claim 17.

## Revendications

1. Encodeur incrémental capacitif comportant au moins trois groupes (71, 72, 73) de différentes surfaces de capteur (7, 7ij), toutes les surfaces de capteur (7i1, 7i2, 7i3, 7i4) du même groupe (7i) étant reliées entre elles de manière électriquement conductrice, les surfaces de capteur (7, 7ij) étant recouvertes d'une plaque de recouvrement (2) électriquement isolante et faisant partie de condensateurs à capacité variable par contact avec la plaque de recouvrement (2), entre chaque fois deux surfaces de capteur (7ij, 7i(j+1)) du même groupe (7i) étant placée respectivement une surface de capteur (7kj, 7mj) de chacun des autres groupes (7k, 7m), chaque groupe (71, 72, 73) étant relié de manière électriquement conductrice à une source de tension (25), de telle sorte qu'un signal de tension peut être appliqué à chaque groupe (71, 72, 73), et chaque groupe (71, 72, 73) étant relié à un circuit d'évaluation (14), de telle sorte que respectivement un signal de sortie (S) peut être évalué pour chaque groupe (71, 72, 73), sachant que pour déclencher un pas de l'encodeur incrémental (4), un premier seuil de signal (S1) est prévu pour le signal de sortie (S), **caractérisé en ce que** pour déclencher un pas suivant de l'encodeur incrémental (4), un deuxième seuil de signal (S2) est prévu pour le signal de sortie (S), et **en ce qu'**un pas de l'encodeur incrémental (4) est compté avec un incrément prédéfini dès que le signal de sortie (S) d'un groupe (7i) de surfaces de capteur (7ij) dépasse le premier seuil de signal (S1) et un pas suivant est compté dès que le même signal de sortie (S) dépasse le deuxième seuil de signal (S2).

2. Encodeur incrémental selon la revendication 1, **caractérisé en ce qu'**un actionnement de l'encodeur incrémental (4) peut être déterminé à partir des signaux de sortie cumulés des différents groupes (71, 72, 73).

3. Encodeur incrémental selon la revendication 1 ou 2, **caractérisé en ce que** le signal de tension est un signal d'horloge.

4. Encodeur incrémental selon la revendication 3, **caractérisé en ce que** les surfaces de capteur (7ij) d'un groupe (7i) sont reliées chacune à une sortie de commande (19) d'un commutateur à semi-conducteur (18), lequel possède en outre une entrée de signal (21) avec ledit signal d'horloge (28) et une sortie de signal (22), et **en ce qu'**est appliqué à la sortie de signal (22) du commutateur à semi-conducteur (18) le signal de sortie qui suit le signal d'horloge (28), avec des composantes de signal qui sont proportionnelles à la capacité des condensateurs (17) formés par les surfaces de capteur (7ij) du groupe (7i).

5. Encodeur incrémental selon la revendication 4, **caractérisé en ce que** l'entrée de commande (19) est conçue pour alimenter les surfaces de capteur (7, 7ij) avec le signal d'horloge (28), et **en ce que** pendant une période de charge du condensateur (17) par le signal d'horloge, le signal de sortie est appliqué à la sortie de signal (22) du commutateur à semi-conducteur (18).

6. Encodeur incrémental selon la revendication 4 ou 5, **caractérisé en ce que** le commutateur à semi-conducteur (18) comporte un transistor, et **en ce que** les surfaces de capteur (7, 7ij) sont reliées à la base du transistor.

7. Encodeur incrémental selon l'une des revendications 4 à 6, **caractérisé en ce que**, pour être alimentée avec le signal d'horloge (28), l'entrée de signal (21) est reliée à une sortie (25) d'un microprocesseur (26).

8. Encodeur incrémental selon l'une des revendications 3 à 7, **caractérisé en ce que** le signal d'horloge (28) est un signal d'horloge périodique, en particulier un signal rectangulaire.

9. Encodeur incrémental selon l'une des revendications 3 à 8, **caractérisé en ce que** les surfaces de capteur (7) présentent chacune une protection active et **en ce que** la protection active est formée par une surface de protection (11) à laquelle, en même temps que les surfaces de capteur (7), est appliqué le signal d'horloge (28).

10. Encodeur incrémental selon la revendication 9, **caractérisé en ce que** les surfaces de capteur (7) sont disposées sur la face avant d'un support (5), et la surface de protection (11) est disposée sur la face arrière du support (5), au moins au niveau des surfaces de capteur (7).

11. Encodeur incrémental selon la revendication 10, **caractérisé en ce que** le support (5) est espacé de la plaque de recouvrement (2), et **en ce que**, entre plaque de recouvrement (2) et support (5), un corps (8) électriquement conducteur est prévu pour chacune des surfaces de capteur (7), qui couvre l'espacement et qui est relié de manière électriquement conductrice à la surface de capteur (7) respective et/ou forme au moins avec une partie de sa surface au moins une partie de la surface de capteur (7) respective.

12. Encodeur incrémental selon la revendication 11, **caractérisé en ce qu'**au moins un composant électronique (18, 20, 23, 35) est disposé de telle façon qu'il pénètre dans une cavité entourée par le corps (8) électriquement conducteur.

13. Encodeur incrémental selon la revendication 12, **caractérisé en ce que** le composant électronique est le commutateur à semi-conducteur (18, 20, 23) et/ou un élément lumineux (35).

14. Encodeur incrémental selon la revendication 11 ou 12, **caractérisé en ce que** le corps (8) électriquement conducteur est un ressort de compression torsadé réalisé à partir d'un corps allongé.

15. Encodeur incrémental selon l'une des revendications précédentes, **caractérisé en ce que** les différentes groupes (7i) de surfaces de capteur (7ij) sont commutés selon un procédé de multiplexage temporel.

16. Encodeur incrémental selon l'une des revendications précédentes, **caractérisé en ce que** les surfaces de capteur (7ij) sont disposées en ligne droite ou en forme d'arc ou en forme d'anneau.

17. Champ d'entrée pour un appareil ménager, doté d'au moins un encodeur incrémental (4) selon l'une des revendications 1 à 16.

18. Appareil ménager doté d'un champ d'entrée (3) selon la revendication 17.
